# EUROPEAN PATENT APPLICATION

(11) **EP 4 411 508 A1**
(43) Date of publication of application: **07.08.2024**
(21) Application number: 22876000.5
(22) Date of filing: 21.09.2022
(51) Int. Cl.: G06F 1/16, H05K 5/02

(54) **ELECTRONIC DEVICE**

(30) Priority: 29.09.2021 JP 2021159311
(71) Applicant: Panasonic Intellectual Property Management Co., Ltd., Kadoma-shi, Osaka 571-0057 (JP)
(72) Inventor: KONDOU, Yasunori, Kadoma-shi, Osaka 571-0057 (JP); INOUE, Takumi, Kadoma-shi, Osaka 571-0057 (JP)
(74) Representative: Grünecker Patent- und Rechtsanwälte PartG mbB
(86) International application number: PCT/JP2022/035252
(87) International publication number: WO 2023/054133

(57) **Abstract**

An electronic device of the present disclosure includes: a housing; a display disposed in the housing; an imaging unit disposed in the housing and positioned around the display in a planar view of the housing; and a plurality of microphones disposed in the housing and positioned around the imaging unit in a planar view of the housing. The plurality of microphones are disposed at positions closer to the display than the imaging unit or at positions farther from the display than the imaging unit in a first direction in which the display and the imaging unit are adjacent to each other, and are disposed side by side at intervals in a second direction intersecting the first direction.

## Description

### TECHNICAL FIELD

the present disclosure relates to an electronic device.

### BACKGROUND ART

Patent Literature 1 discloses a sound data processing device including a plurality of microphones. The device described in Patent Literature 1 includes a first housing and a second housing capable of changing a position relative to the first housing. A microphone is disposed in each of the first housing and the second housing. The device described in Patent Literature 1 detects a positional relationship between a first housing and a second housing, obtains a positional relationship between a plurality of microphones from the positional relationship, performs sound source separation processing on sound data taken in from the plurality of microphones on the basis of the obtained positional relationship, and emphasizes or attenuates sound data from a specific sound source.

### Citation List

### Patent Literature

PTL 1: Unexamined Japanese Patent Publication No. 2013-229899

### SUMMARY OF THE INVENTION

An object of the present disclosure is to provide an electronic device capable of improving the degree of freedom of components arranged in a housing.

An electronic device according to one aspect of the present disclosure includes:
a housing;
a display disposed in the housing;
an imaging unit disposed in the housing and positioned around the display in a planar view of the housing; and
a plurality of microphones arranged in the housing and positioned around the imaging unit in a planar view of the housing, in which
the plurality of microphones are arranged at positions closer to the display than the imaging unit or at positions farther from the display than the imaging unit in a first direction in which the display and the imaging unit are adjacent to each other, and are arranged side by side at intervals in a second direction intersecting the first direction.

According to the present disclosure, it is possible to provide an electronic device capable of improving the degree of freedom of components disposed in a housing.

### BRIEF DESCRIPTION OF THE DRAWINGS

Fig. 1 is a schematic perspective view of an example of an electronic device according to a first exemplary embodiment according to the present disclosure.
Fig. 2 is a schematic front view of an example of a first housing in the electronic device.
Fig. 3 is a schematic view illustrating an internal structure of the electronic device in a state where a cover and a frame of the first housing are removed.
Fig. 4 is a schematic enlarged view of a Z1 portion of the electronic device of Fig. 2.
Fig. 5 is a schematic enlarged view of a Z2 portion of the electronic device of Fig. 3.
Fig. 6 is a schematic cross-sectional view of the electronic device of Fig. 4 taken along line A-A.
Fig. 7 is a schematic cross-sectional view of the electronic device of Fig. 4 taken along line B-B.

### DESCRIPTION OF EMBODIMENT

### (Background of present disclosure)

As the electronic device, for example, a notebook type personal computer (laptop PC) and a tablet PC in which a display, an imaging unit, and a plurality of microphones (array microphones) are disposed are known. As such an electronic device, a configuration is known in which a plurality of microphones are disposed side by side in one direction at equal intervals, and an imaging unit is disposed between the plurality of microphones. For example, in an electronic device including four microphones, an imaging element or the like constituting an imaging unit is disposed between two central microphones.

However, in a case where an imaging element or the like is disposed between a plurality of microphones, a region where the plurality of microphones are disposed tends to be large with respect to the housing. For example, when the region in which the plurality of microphones are disposed becomes larger in the width direction of the housing, the regions formed on both sides of the plurality of microphones in the housing become smaller. Therefore, a degree of freedom of arrangement of other components is reduced in regions on both sides of the plurality of microphones.

For example, communication antennas may be disposed in regions on both sides of the plurality of microphones. In recent years, it is required to increase the antenna size in order to support the fifth generation mobile communication system (5G: 5th Generation). The larger the region in which the plurality of microphones are disposed, the more difficult it is to dispose a relatively large antenna such as a 5G antenna in the regions on both sides of the plurality of microphones.

The housing is provided with sound holes at positions corresponding to the plurality of microphones. In a case where the imaging unit has a shutter that shields the imaging element in a configuration in which the imaging unit is disposed between the plurality of microphones, for example, a through hole is provided in the shutter in order to prevent the sound hole from being blocked by opening and closing of the shutter. In this case, when the shutter is open, the through hole of the shutter forms a part of the sound hole. Since the dimension of the sound hole affects the characteristics of the microphone, the through hole is designed so as not to deteriorate the characteristics of the microphone. Therefore, there is a problem that the design becomes complicated.

Therefore, in order to solve the above problems, the present inventors have found a configuration in which a plurality of microphones are disposed at positions closer to the display than the imaging unit or at positions farther from the display than the imaging unit in a direction in which the display and the imaging unit are adjacent to each other, and have reached the present disclosure.

An electronic device according to a first aspect of the present disclosure includes: a housing; a display disposed in the housing; an imaging unit disposed in the housing and positioned around the display in a planar view of the housing; and a plurality of microphones disposed in the housing and positioned around the imaging unit in a planar view of the housing, in which the plurality of microphones are positioned at positions closer to the display than the imaging unit or at positions farther from the display than the imaging unit in a first direction in which the display and the imaging unit are adjacent to each other, and are positioned side by side at intervals in a second direction intersecting the first direction.

With such a configuration, it is possible to improve the degree of freedom of components disposed in the housing.

In an electronic device according to a second aspect of the present disclosure, the plurality of microphones may be disposed between the display and the imaging unit.

With such a configuration, the degree of freedom of the components disposed in the housing can be further improved.

An electronic device according to a third aspect of the present disclosure may further include an elastic member disposed between the housing and the plurality of microphones, the housing may be provided with a plurality of first through holes, and the elastic member may be provided with a plurality of second through holes connected to the plurality of first through holes.

With such a configuration, the sound holes of the plurality of microphones can be easily formed with a simple configuration.

In an electronic device according to a fourth aspect of the present disclosure, the housing may have a flat surface that is in contact with the elastic member, and the elastic member may be pressed by the flat surface.

With such a configuration, the elastic member can be uniformly pressed by the flat surface, and a gap variation between the housing and the plurality of microphones can be absorbed. Thus, the sound hole including the plurality of first through holes and the plurality of second through holes can be easily formed.

An electronic device according to a fifth aspect of the present disclosure may further include a substrate having a mounting surface on which the plurality of microphones and the imaging unit are mounted, in which the mounting surface of the substrate includes a first region in which the imaging unit is mounted and a second region in which the plurality of microphones are mounted, and the first region and the second region are disposed separately in the first direction.

With such a configuration, the degree of freedom of the components disposed in the housing can be further improved. In addition, the heights of the elements disposed in the second region can be unified.

An electronic device according to a sixth aspect of the present disclosure may further include antennas disposed in the housing, in which the antennas may be disposed in regions disposed on both sides of the plurality of microphones in a planar view of the housing.

With such a configuration, the degree of freedom in the arrangement of the antenna can be improved. For example, a relatively large antenna compatible with 5G or the like can be disposed.

In an electronic device according to a seventh aspect of the present disclosure, when a total length of the housing on a side where the imaging unit and the plurality of microphones are disposed in a planar view of the housing is 100, a region in which the plurality of microphones are disposed may have a first dimension of between 25 and 40 (inclusive), and the two regions may have a sum of second dimensions of more than or equal to 30.

With such a configuration, the degree of freedom in the arrangement of the antenna can be further improved.

In an electronic device according to an eighth aspect of the present disclosure, the imaging unit and the plurality of microphones may be positioned in an upper center in a planar view of the housing.

With such a configuration, the degree of freedom of the components disposed in the housing can be further improved.

In an electronic device according to a ninth aspect of the present disclosure, the imaging unit may include an imaging element and a shutter that shields the imaging element, and the shutter may shield the imaging element by moving in the second direction.

With such a configuration, since the shutter and the plurality of microphones do not overlap each other, the shutter can have a simpler configuration.

Hereinafter, exemplary embodiments of the present disclosure will be described with reference to the accompanying drawings. In addition, in each drawing, each element is exaggerated in order to facilitate the description.

In this specification, the terms "first", "second", and the like are only used for description, and should not be understood as explicitly or implying relative importance or a rank of a technical feature. Features limited to "first" and "second" are intended to imply the inclusion of one or more such features.

### (First exemplary embodiment)

### [Overall configuration of electronic device]

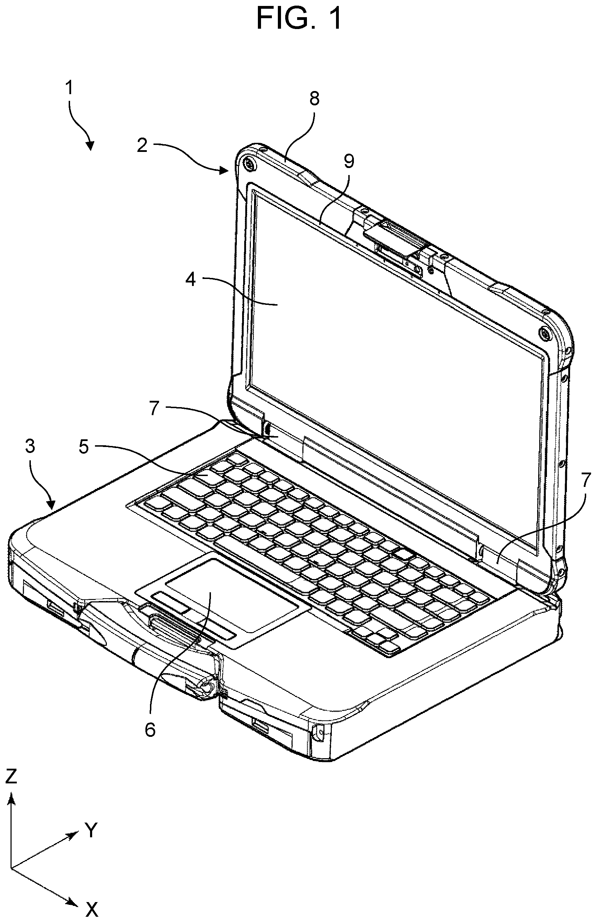

Fig. 1 is a schematic perspective view of an example of electronic device 1 according to the first exemplary embodiment according to the present disclosure. Note that X, Y, and Z directions in the drawing indicate a width direction, a depth direction, and a height direction of electronic device 1, respectively.

As illustrated in Fig. 1, electronic device 1 is a notebook personal computer (laptop PC). Electronic device 1 includes first housing 2 and second housing 3. Each of first housing 2 and second housing 3 has a thin box-shaped outer contour and has a rectangular shape.

First housing 2 houses display 4. Display 4 is, for example, a liquid crystal. A display surface of display 4 is exposed from first housing 2. First housing 2 also houses an array microphone, an imaging unit, an antenna, and the like.

Second housing 3 houses an input unit. The input unit is, for example, keyboard 5 and touch pad 6. The input unit is exposed from second housing 3. In the present specification, keyboard 5 and touch pad 6 may be referred to as input units 5 and 6. A circuit such as a CPU and a memory, a battery, and the like are housed inside second housing 3.

First housing 2 and second housing 3 are connected via hinge 7. Hinge 7 rotatably connects first housing 2 and second housing 3. Hinge 7 allows first housing 2 and/or second housing 3 to rotate and bring electronic device 1 into an open state or a closed state. The "open state" means a state in which first housing 2 and second housing 3 are separated from each other and display 4 and input units 5 and 6 are exposed. The "closed state" means a state in which first housing 2 and second housing 3 are disposed to face each other, display 4 and input units 5 and 6 face each other, and display 4 and input units 5 and 6 are not exposed.

First housing 2 and second housing 3 are made of a metal material. For example, first housing 2 and second housing 3 are made of magnesium alloy.

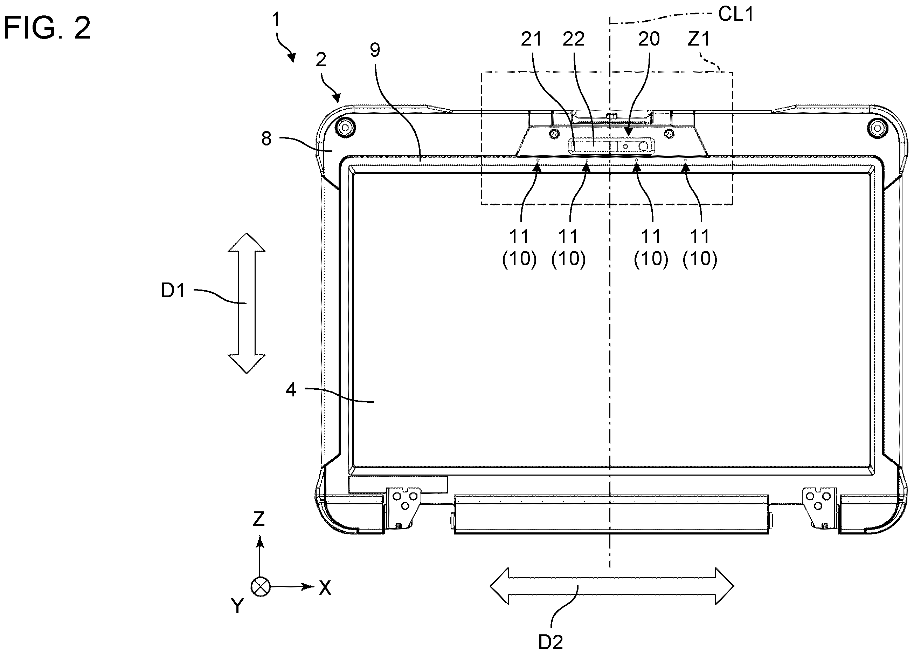

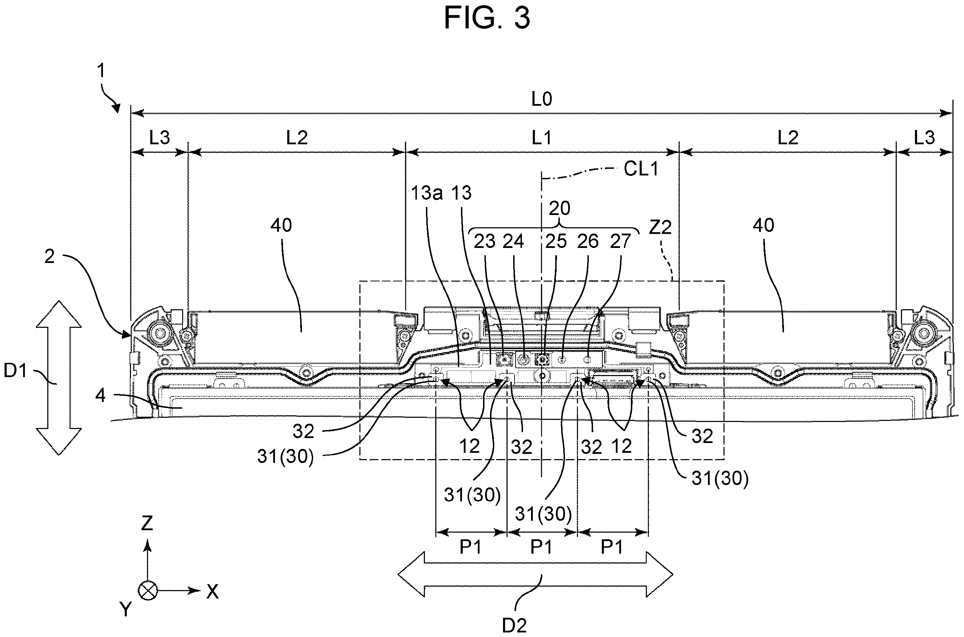

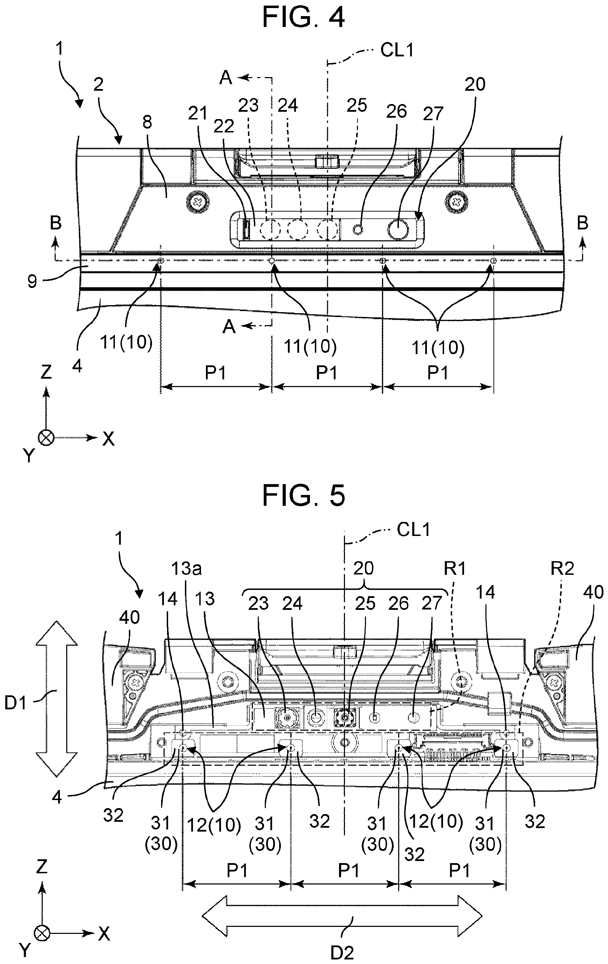

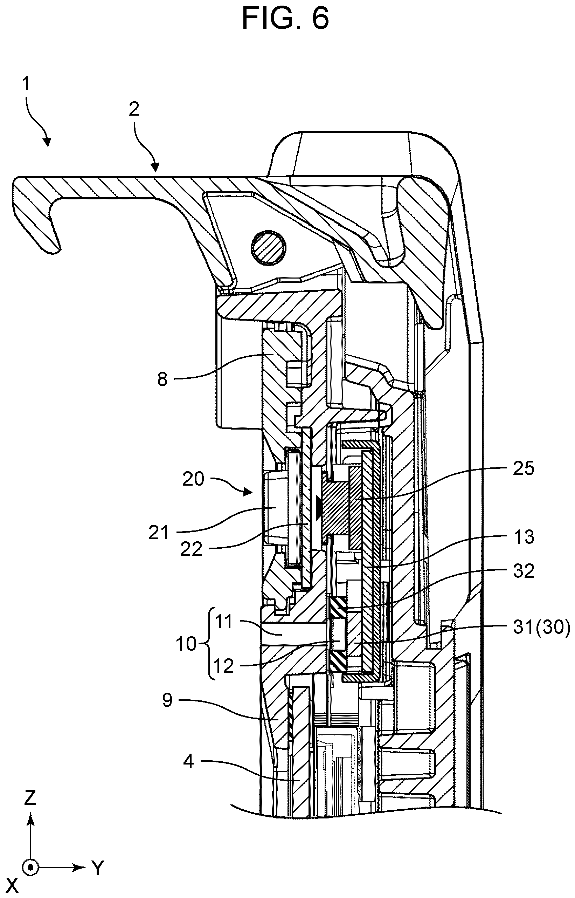

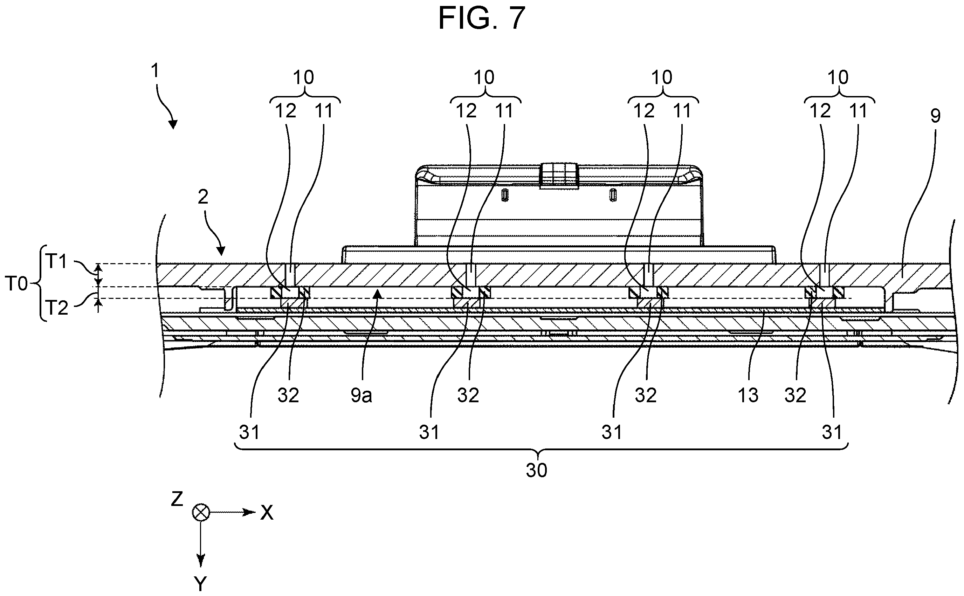

Fig. 2 is a schematic front view of an example of first housing 2 in electronic device 1. Fig. 3 is a schematic view illustrating an internal structure of electronic device 1 with cover 8 and frame 9 of first housing 2 removed. Fig. 4 is a schematic enlarged view of a Z1 portion of electronic device 1 of Fig. 2. Fig. 5 is a schematic enlarged view of a Z2 portion of electronic device 1 of Fig. 3. Fig. 6 is a schematic cross-sectional view of electronic device 1 of Fig. 4 taken along line A-A. Fig. 7 is a schematic cross-sectional view of electronic device 1 of Fig. 4 taken along line B-B.

As illustrated in Figs. 2 to 7, display 4, imaging unit 20, array microphone 30, and antenna 40 are disposed in first housing 2. Array microphone 30 includes a plurality of microphones 31.

In the present exemplary embodiment, an example in which antenna 40 is disposed in first housing 2 will be described, but the present invention is not limited thereto. For example, antenna 40 does not need to be disposed in first housing 2. Alternatively, components other than antenna 40 may be disposed in first housing 2.

First housing 2 includes cover 8 and frame 9.

As illustrated in Figs. 2 and 4, cover 8 is a portion that defines the outer contour of first housing 2, and has a frame shape in a planar view of first housing 2. Specifically, cover 8 is disposed so as to cover imaging unit 20 and antenna 40 disposed around display 4. Cover 8 is provided with a hole for exposing imaging unit 20. Note that "in a planar view of first housing 2" means that it is viewed from a thickness direction of first housing 2, that is, a Y direction in the drawing. In the present exemplary embodiment, cover 8 includes a plurality of parts.

Frame 9 is disposed inside cover 8 in a planar view of first housing 2 and surrounds an outer periphery of display 4. Frame 9 has a frame shape in a planar view of first housing 2. Frame 9 is disposed at a position overlapping array microphone 30 in a planar view of first housing 2.

Frame 9 is provided with a plurality of first through holes 11. Specifically, the plurality of first through holes 11 are provided at an upper center in a planar view of first housing 2. The plurality of first through holes 11 are provided at positions overlapping the plurality of microphones 31 in a planar view of first housing 2. The plurality of first through holes 11 are provided at predetermined intervals P1 in a width direction (X direction) of first housing 2. In a case where a direction in which display 4 and imaging unit 20 are adjacent to each other is first direction D1, the plurality of first through holes 11 are provided side by side along second direction D2 intersecting first direction D1. Second direction D2 may be orthogonal to first direction D1. In the present exemplary embodiment, first direction D1 is a height direction (Z direction) of first housing 2, and second direction D2 is a width direction (X direction) of first housing 2.

The plurality of first through holes 11 form a part of sound holes 10 of the plurality of microphones 31. First through hole 11 is, for example, a circular hole.

As illustrated in Figs. 2, 4, and 5, imaging unit 20 is a portion having a function of imaging an imaging target. Imaging unit 20 is positioned around display 4 in a planar view of first housing 2. Specifically, imaging unit 20 is provided on a side where the display screen of display 4 is exposed in first housing 2. Furthermore, imaging unit 20 is provided in the upper center in a planar view of first housing 2.

Imaging unit 20 includes shutter 21, protective sheet 22, first imaging element 23, light emitting element 24, second imaging element 25, LED 26, and sensor 27.

First imaging element 23, light emitting element 24, second imaging element 25, LED 26, and sensor 27 are disposed side by side in the width direction (X direction) of first housing 2. First imaging element 23, light emitting element 24, second imaging element 25, LED 26, and sensor 27 are disposed side by side along second direction D2 intersecting first direction D1 in which display 4 and imaging unit 20 are adjacent to each other.

Imaging unit 20 has a longitudinal direction and a lateral direction in a planar view of first housing 2. The longitudinal direction of imaging unit 20 corresponds to second direction D2, and the lateral direction of imaging unit 20 corresponds to first direction D 1.

Shutter 21 shields first imaging element 23 and second imaging element 25. Shutter 21 is formed of a member having a rectangular plate shape. Shutter 21 shields first imaging element 23 and second imaging element 25 by moving in second direction D2 in which first imaging element 23 and second imaging element 25 are arranged.

In the present exemplary embodiment, shutter 21 shields first imaging element 23, light emitting element 24, and second imaging element 25 by moving in second direction D2 in which first imaging element 23 and second imaging element 25 are arranged.

Protective sheet 22 protects first imaging element 23, light emitting element 24, and second imaging element 25. Protective sheet 22 is formed of, for example, a transparent sheet member.

First imaging element 23 is an infrared camera, light emitting element 24 is an infrared LED, and second imaging element 25 is an RGB camera. LED 26 is an operation check LED, and sensor 27 is an illuminance sensor.

Note that imaging unit 20 only needs to include one or a plurality of imaging elements. For example, imaging unit 20 only needs to include first imaging element 23 and/or second imaging element 25. In imaging unit 20, shutter 21, protective sheet 22, light emitting element 24, LED 26, and sensor 27 are not essential components. Furthermore, imaging unit 20 may replace these elements with other elements or may add other elements.

As illustrated in Figs. 3 and 5, array microphone 30 includes a plurality of microphones 31.

The plurality of microphones 31 are disposed in first housing 2 and are positioned around imaging unit 20 in a planar view of first housing 2. In the present exemplary embodiment, the plurality of microphones 31 are disposed at positions closer to display 4 than imaging unit 20 in first direction D1 in which display 4 and imaging unit 20 are adjacent to each other. First direction D1 is a direction in which display 4 and imaging unit 20 are disposed side by side in a planar view of first housing 2.

In the present exemplary embodiment, display 4 and imaging unit 20 are disposed with an interval in a planar view of first housing 2, and the plurality of microphones 31 are disposed between display 4 and imaging unit 20 in a planar view of first housing 2. The plurality of microphones 31 are provided in the upper center of first housing 2 in a planar view of first housing 2. The plurality of microphones 31 are disposed at positions overlapping with frame 9 of first housing 2 in a planar view of first housing 2.

Note that the plurality of microphones 31 may be disposed at positions farther from display 4 than imaging unit 20 in first direction D1. The plurality of microphones 31 may be disposed at positions closer to display 4 than imaging unit 20 or positions farther from display 4 than imaging unit 20 in first direction D1 in which display 4 and imaging unit 20 are adjacent to each other. In other words, the plurality of microphones 31 may be positioned on the outer peripheral side in the lateral direction (first direction D1) of imaging unit 20 in a planar view of first housing 2. The plurality of microphones 31 are not positioned in imaging unit 20 and on the outer peripheral side in the longitudinal direction (second direction D2) of imaging unit 20.

Further, the plurality of microphones 31 are disposed side by side at interval P1 in second direction D2 intersecting first direction D1. For example, the plurality of microphones 31 are disposed at equal intervals. In the present exemplary embodiment, the plurality of microphones 31 are disposed symmetrically with respect to center line CL1 of first housing 2 extending in the height direction (Z direction) in a planar view of first housing 2.

In the present exemplary embodiment, array microphone 30 includes four microphones 31. Note that the number of microphones 31 is not limited to four. The number of microphones 31 may be more than or equal to two.

As illustrated in Figs. 3 and 5, imaging unit 20 and the plurality of microphones 31 are mounted on substrate 13. Substrate 13 has mounting surface 13a on which imaging unit 20 and the plurality of microphones 31 are mounted. Mounting surface 13a of substrate 13 includes first region R1 on which imaging unit 20 is mounted and second region R2 on which the plurality of microphones 31 are mounted.

First region R1 is a region where elements constituting imaging unit 20 are disposed on mounting surface 13a of substrate 13. In first region R1, first imaging element 23, light emitting element 24, second imaging element 25, LED 26, and sensor 27 are disposed side by side along second direction D2.

Second region R2 is a region where the plurality of microphones 31 are disposed on mounting surface 13a of substrate 13. In second region R2, the plurality of microphones 31 are disposed side by side at a predetermined interval P1 along second direction D2.

In a planar view of first housing 2, first region R1 and second region R2 are disposed separately in first direction D 1. That is, in a planar view of first housing 2, first region R1 and second region R2 are disposed to be shifted in first direction D1. Specifically, in a planar view of first housing 2, second region R2 is formed at a position closer to display 4 than first region R1 on mounting surface 13a. In a planar view of first housing 2, first region R1 is formed at a position farther from display 4 than second region R2 on mounting surface 13a. In a planar view of first housing 2, first region R1 and second region R2 do not overlap each other.

As illustrated in Figs. 6 and 7, a plurality of elastic members 32 are disposed between first housing 2 and the plurality of microphones 31 in the depth direction (Y direction) of first housing 2. Specifically, the plurality of elastic members 32 are interposed between frame 9 of first housing 2 and the plurality of microphones 31.

Elastic member 32 is an elastically deformable member. Elastic member 32 is formed of, for example, a rectangular plate-like member. Elastic member 32 is formed of, for example, urethane foam, silicon rubber, or the like.

Elastic member 32 is provided with second through hole 12. Second through hole 12 is, for example, a circular hole. Second through hole 12 is connected to first through hole 11 provided in frame 9, and forms a part of sound hole 10. As illustrated in Fig. 7, the plurality of microphones 31 are configured to receive sounds having passed through the plurality of first through holes 11 and the plurality of second through holes 12.

In the present exemplary embodiment, as illustrated in Fig. 5, substrate 13 is provided with two positioning holes 14 around the plurality of microphones 31. In addition, first housing 2 is provided with two protruding portions to be inserted into two positioning holes 14. By inserting the two protruding portions into the two positioning holes, first housing 2 can be easily positioned with respect to substrate 13. Accordingly, sound hole 10 can be formed by easily connecting first through hole 11 and second through hole 12.

Sound hole 10 is formed by first through hole 11 provided in frame 9 of first housing 2 and second through hole 12 provided in elastic member 32. Depth T0 of sound hole 10 is determined by a sum of depth T1 of first through hole 11 and depth T2 of the second through hole.

Depth T2 of second through hole 12 of elastic member 32 can be dimensionally adjusted by elastic member 32 being elastically deformed. For example, by applying a force in the thickness direction (Y direction) of elastic member 32, the thickness of elastic member 32 is reduced. When the thickness of elastic member 32 decreases, depth T2 of second through hole 12 also decreases. In this manner, depth T2 of second through hole 12 can be easily adjusted by applying a force in the thickness direction (Y direction) of elastic member 32.

Frame 9 of first housing 2 has flat surface 9a in contact with the plurality of elastic members 32. Flat surface 9a is a flat surface formed by the inner wall of frame 9 of first housing 2. Frame 9 uniformly presses the plurality of elastic members 32 by flat surface 9a. That is, the plurality of elastic members 32 are uniformly pressed by flat surface 9a of first housing 2. For this reason, the plurality of elastic members 32 are easily elastically deformed by an equal deformation amount in the thickness direction (Y direction). Thus, depth T2 of the plurality of second through holes 12 can be uniformly adjusted.

Furthermore, as described above, on mounting surface 13a of substrate 13, first region R1 on which imaging unit 20 is mounted and second region R2 on which the plurality of microphones 31 are mounted are disposed separately in first direction D1. The elements constituting imaging unit 20 and the plurality of microphones 31 have different heights. Therefore, by disposing imaging unit 20 and the plurality of microphones 31 separately in first region R1 and second region R2, the heights of the plurality of elements (the plurality of microphones 31) disposed in second region R2 can be unified. This makes it easy to evenly press the plurality of elastic members 32 by flat surface 9a.

In the present exemplary embodiment, four elastic members 32 are disposed corresponding to four microphones 31. Note that the number of elastic members 32 is not limited to four. The number of elastic members 32 may be one or more. For example, one elastic member 32 may be disposed across the plurality of microphones 31. In this case, a plurality of second through holes 12 may be provided in one elastic member 32.

As illustrated in Figs. 3 and 5, antenna 40 is disposed at a position that does not interfere with imaging unit 20 and the plurality of microphones 31. Two antennas 40 are respectively disposed in two regions formed on both sides of the plurality of microphones 31 in a planar view of first housing 2.

Antenna 40 is formed of, for example, a conductive material, and can communicate with an external device. Antenna 40 is, for example, a 5G, Wi-Fi, and/or WWAN (Wireless Wide Area Network) compatible antenna. Antenna 40 can transmit and receive a 5th generation new radio (5GNR) signal, a wireless local area network (WLAN) signal, and/or a WWAN signal.

As illustrated in Fig. 3, in a planar view of first housing 2, total length L0 of first housing 2 on a side where imaging unit 20 and the plurality of microphones 31 are disposed is defined as 100. Total length L0 of first housing 2 is the maximum dimension in the width direction (X direction) of first housing 2 in a planar view of first housing 2.

In this case, first dimension L1 of the region where the plurality of microphones 31 are disposed is between 25 and 40 (inclusive), and the total of second dimension L2 of the region where antenna 40 is disposed is more than or equal to 30. The sum of third dimensions L3 of a region where the other components can be disposed is less than or equal to 25. Note that the region where the other components can be disposed is a region other than the region where the plurality of microphones 31 are disposed and the region where antenna 40 is disposed, and means a region where other components can be disposed. The region where other components can be disposed is, for example, a region where a fixture such as a screw is disposed.

Interval P1 between the plurality of microphones 31 is designed to have a maximum value in first dimension L1. Accordingly, sound collection performance of the plurality of microphones 31 can be improved.

### [Effects]

According to electronic device 1 of the first exemplary embodiment, the following effects can be obtained.

Electronic device 1 includes housing 2, display 4, imaging unit 20, and a plurality of microphones 31. Display 4 is disposed in housing 2. Imaging unit 20 is disposed in housing 2 and is positioned around display 4 in a planar view of housing 2. The plurality of microphones 31 are disposed in housing 2 and are positioned around imaging unit 20 in a planar view of housing 2. The plurality of microphones 31 are disposed at positions closer to display 4 than imaging unit 20 or at positions farther from display 4 than imaging unit 20 in first direction D1 in which display 4 and imaging unit 20 are adjacent to each other. Further, the plurality of microphones 31 are disposed side by side at interval P1 in second direction D2 intersecting first direction D1.

With such a configuration, the degree of freedom of components disposed in housing 2 can be improved. Specifically, since imaging unit 20 and the plurality of microphones 31 are disposed to be shifted in first direction D1, it is possible to reduce a region where the plurality of microphones 31 are disposed in the second direction intersecting first direction D1. As a result, it is possible to increase the space of the regions formed on both sides of the region where the plurality of microphones 31 are disposed. Therefore, it is possible to secure a space for disposing other components on both sides of the plurality of microphones 31.

As described above, according to electronic device 1, the degree of freedom of the components disposed in housing 2 can be improved with a simple configuration.

The plurality of microphones 31 are disposed between display 4 and imaging unit 20. With such a configuration, the degree of freedom of the components disposed in housing 2 can be further improved.

Electronic device 1 further includes elastic member 32 disposed between housing 2 and the plurality of microphones 31. Housing 2 is provided with a plurality of first through holes 11, and elastic member 32 is provided with a plurality of second through holes 12 connected to the plurality of first through holes 11. With such a configuration, sound hole 10 connected to the plurality of microphones 31 can be easily formed by the plurality of first through holes 11 and the plurality of second through holes 12.

Housing 2 has flat surface 9a in contact with elastic member 32, and elastic member 32 is pressed by flat surface 9a. With such a configuration, elastic member 32 is pressed by flat surface 9a, and a gap variation between housing 2 and the plurality of microphones 31 can be easily absorbed. As a result, sound hole 10 including the plurality of first through holes and the plurality of second through holes can be easily formed.

Electronic device 1 further includes substrate 13 having a mounting surface on which the plurality of microphones 31 and imaging unit 20 are mounted. Mounting surface 13a of substrate 13 includes first region R1 on which imaging unit 20 is mounted and second region R2 on which the plurality of microphones 31 are mounted. First region R1 and second region R2 are disposed separately in first direction D1. With such a configuration, the heights of the elements disposed in second region R2 can be unified. Since the heights of the imaging element and microphone 31 are different, the heights of the elements can be made uniform by disposing the elements separately in first region R1 and second region R2. As a result, in second region R2, elastic member 32 is easily pressed more uniformly by flat surface 9a of first housing 2.

Electronic device 1 further includes antenna 40 disposed in housing 2. Antennas 40 are disposed in regions formed on both sides of the plurality of microphones 31 in a planar view of housing 2. With such a configuration, antennas 40 having a relatively large dimension can be disposed in regions formed on both sides of the plurality of microphones 31. As a result, for example, a 5G-compatible antenna or the like can be disposed in regions formed on both sides of the plurality of microphones 31.

In a planar view of housing 2, total length L0 of housing 2 on a side where imaging unit 20 and the plurality of microphones 31 are disposed is set to 100. In this case, first dimension L1 of the region where the plurality of microphones 31 are disposed is between 25 and 40 (inclusive), and the total of second dimension L2 of the region where antenna 40 is disposed is more than or equal to 30. With such a configuration, antennas 40 having a relatively large dimension can be disposed in regions formed on both sides of the plurality of microphones 31.

Imaging unit 20 and the plurality of microphones 31 are positioned in the upper center in a planar view of housing 2. With such a configuration, the degree of freedom of the components disposed in housing 2 can be further improved.

Imaging unit 20 includes imaging element 23 and shutter 21 that shields imaging element 23. Shutter 21 shields imaging element 23 by moving in second direction D2. With such a configuration, shutter 21 and sound hole 10 do not interfere with each other. Specifically, shutter 21 does not overlap the plurality of microphones 31 in a planar view of housing 2, and thus shutter 21 does not block sound hole 10. As a result, it is not necessary to provide a through hole or the like for not blocking sound hole 10 in shutter 21, and a simpler design is obtained.

In the present exemplary embodiment, an example in which electronic device 1 is a laptop PC has been described, but the present invention is not limited thereto. For example, electronic device 1 may be a tablet PC, a smartphone, or another information processing device.

In the present exemplary embodiment, an example in which imaging unit 20 and array microphone 30 (the plurality of microphones 31) are disposed in the upper center in a planar view of first housing 2 has been described, but the present invention is not limited thereto. For example, imaging unit 20 and array microphone 30 (the plurality of microphones 31) may be disposed around display 4 in a planar view of first housing 2.

In the present exemplary embodiment, an example in which antennas 40 are disposed in the regions formed on both sides of the plurality of microphones 31 has been described, but the present invention is not limited thereto. For example, components other than antennas 40 may be disposed in regions formed on both sides of the plurality of microphones 31.

In the present exemplary embodiment, an example in which the inner wall of frame 9 of first housing 2 is flat surface 9a has been described, but the present invention is not limited thereto. For example, a protruding portion that protrudes from the inner wall of frame 9 of first housing 2 toward elastic member 32 may be provided, and a surface of the protruding portion that comes into contact with elastic member 32 may be flat surface 9a.

Although the present disclosure has been fully described with reference to preferred exemplary embodiments and with reference to the accompanying drawings, various changes and modifications will become apparent to those skilled in the art. Such variations and modifications are to be understood as being included within the scope of the present disclosure as set forth in the appended scope of claims unless departing from the scope of the present disclosure.

### INDUSTRIAL APPLICABILITY

Since the present disclosure can improve the degree of freedom of components disposed in a housing, the present disclosure is applied to, for example, an electronic device (For example, a laptop PC, a tablet PC, or the like).

### REFERENCE MARKS IN THE DRAWINGS

1: electronic device
2: first housing
3: second housing
4: display
5: keyboard
6: touch pad
7: hinge
8: cover
9: frame
9a: flat surface
10: sound hole
11: first through hole
12: second through hole
13: substrate
14: positioning hole
20: imaging unit
21: shutter
22: protective sheet
23: first imaging element
24: light emitting element
25: second imaging element
26: LED
27: sensor
30: array microphone
31: microphone
32: elastic member
40: antenna
CL1: center line
D1: first direction
D2: second direction
L0: total length
L1: first dimension
L2: second dimension
L3: third dimension
P1: interval
T0: depth
T1: depth
T2: depth

## Claims

1. An electronic device comprising:
a housing;
a display disposed in the housing;
an imaging unit disposed in the housing and positioned around the display in a planar view of the housing; and
a plurality of microphones disposed in the housing and positioned around the imaging unit in a planar view of the housing, wherein
the plurality of microphones are disposed at positions closer to the display than the imaging unit or at positions farther from the display than the imaging unit in a first direction in which the display and the imaging unit are adjacent to each other, and are disposed side by side at intervals in a second direction intersecting the first direction.

2. The electronic device according to Claim 1, wherein the plurality of microphones are disposed between the display and the imaging unit.

3. The electronic device according to Claim 1 or 2, further comprising an elastic member disposed between the housing and the plurality of microphones, wherein
the housing is provided with a plurality of first through holes, and
the elastic member is provided with a plurality of second through holes connected to the plurality of first through holes.

4. The electronic device according to Claim 3, wherein the plurality of microphones are configured to receive sounds having passed through the plurality of first through holes and the plurality of second through holes.

5. The electronic device according to Claim 3, wherein
the housing has a surface in contact with the elastic member, and
the elastic member is pressed by the surface of the housing.

6. The electronic device according to any one of Claims 1 to 5, further comprising a substrate having a mounting surface on which the plurality of microphones and the imaging unit are mounted, wherein
the mounting surface of the substrate includes a first region in which the imaging unit is mounted and a second region in which the plurality of microphones are mounted, and
the first region and the second region are disposed separately in the first direction.

7. The electronic device according to any one of Claims 1 to 6, further comprising two antennas disposed in the housing, wherein
the two antennas are respectively disposed in two regions disposed on both sides of the plurality of microphones in a planar view of the housing.

8. The electronic device according to Claim 7, wherein when a total length of the housing on a side where the imaging unit and the plurality of microphones are disposed in a planar view of the housing is 100,
a region in which the plurality of microphones are disposed has a first dimension of between 25 and 40 inclusive, and
the two regions have a sum of second dimensions of more than or equal to 30.

9. The electronic device according to any one of Claims 1 to 8, wherein the imaging unit and the plurality of microphones are positioned in an upper center in a planar view of the housing.

10. The electronic device according to any one of Claims 1 to 9, wherein
the imaging unit includes an imaging element and a shutter that shields the imaging element, and
the shutter shields the imaging element by moving in the second direction.
